(19) Europäisches Patentamt
European Patent Office
Office européen des brevets

(11) **EP 2 126 596 B1**

(12) **EUROPÄISCHE PATENTSCHRIFT**

(45) Veröffentlichungstag und Bekanntmachung des Hinweises auf die Patenterteilung:
**06.04.2011 Patentblatt 2011/14**

(21) Anmeldenummer: **08717084.1**

(22) Anmeldetag: **25.02.2008**

(51) Int Cl.:
*G01R 33/09* *(2006.01)*    *G11B 5/39* *(2006.01)*

(86) Internationale Anmeldenummer:
**PCT/EP2008/052250**

(87) Internationale Veröffentlichungsnummer:
**WO 2008/104518 (04.09.2008 Gazette 2008/36)**

(54) **BETRIEBSVERFAHREN FÜR EINEN MAGNETFELDSENSOR BASIEREND AUF DEM TUNNELMAGNETOWIDERSTANDSEFFEKT UND ZUGEHÖRIGE ANORDNUNG ZUR DURCHFÜHRUNG DIESES VERFAHRENS**

OPERATIONAL METHOD FOR A MAGNETIC FIELD SENSOR BASED ON THE TUNNEL MAGNETO RESISTANCE EFFECT AND ASSOCIATED ARRANGEMENT FOR CARRYING OUT SAID METHOD

PROCÉDÉ DE FONCTIONNEMENT D'UN CAPTEUR DE CHAMP MAGNÉTIQUE SUR LA BASE DE L'EFFET DE MAGNÉTORÉSISTANCE TUNNEL ET DISPOSITIF ASSOCIÉ PERMETTANT LA MISE EN OEUVRE DU PROCÉDÉ

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **26.02.2007 DE 102007009175**

(43) Veröffentlichungstag der Anmeldung:
**02.12.2009 Patentblatt 2009/49**

(73) Patentinhaber: **Siemens Aktiengesellschaft 80333 München (DE)**

(72) Erfinder: **RÜHRIG, Manfred 90542 Eckental (DE)**

(56) Entgegenhaltungen:
**WO-A-2005/010543**

**Beschreibung**

Die Erfindung bezieht sich auf ein Verfahren zum Betreiben eines Magnetfeldsensors basierend auf dem Tunnelmagnetowiderstandseffekt. Daneben bezieht sich die Erfindung auch auf eine Anordnung zur Durchführung des Verfahrens.

Magnetfeldsensoren, die auf dem Tunnelmagnetowiderstandseffekt beruhen - so genannte TMR-Sensoren - sind als sehr leistungsarm bekannt und für energieautarke Messaufgaben prädestiniert, da zum Auslesen nur ein kleiner Tunnelstrom benötigt wird. Trotz der beim TMR-Sensor zu erwartenden potentiell hohen Widerstandsänderungen ist aufgrund der kleinen Ströme allerdings das Signal-Rauschverhältnis (S/N) oftmals ungünstig.

Aus der US 2004/257186 A1 ist ein magnetischer Sensor nach dem messprinzip der Erfassung des Magentowiderstandes und ein zugehöriges Betriebsverfahren bekannt, bei dem der Sensor mit vorgegebener Oszillationsspannung betrieben und über einen Schalter der Oszillationskreis mit bestimmter Frequenz geöffnet wird. Weiterhin ist aus der WO 2005/010543 A1 eine magnetische Sensor-Anordnung auf einem Chip bekannt, bei der das Streufeld von magnetischen Teilchen ausgenutzt wird. Magnetwiderstandsmesseinrichtungen mit Tunneleffekt sind daneben aus der US 2006/0138505 A1 in Schichtbauweise bekannt, wobei dort eine Schicht des Elementes als Referenzschicht dient. Dabei werden bei unterschiedlichen Frequenzen der Realteil und der Imaginärteil der Wechselstromimpedanz erfasst. Schließlich ist aus der WO 2007/042959 A2 ein magnetischer Sensor bekannt, der insbesondere nach dem GMR-Prinzip arbeitet und bei dem unterschiedliche Frequenzen zum Einsatz kommen.

Aufgabe der Erfindung ist es daher, speziell für Tunnel-Magnetowiderstandselemente ein Auswerteverfahren vorzuschlagen, mit dem das Signal-/Rauschverhältnis (S/N) verbessert werden kann. Dazu soll eine geeignete Anordnung zur Durchführung des Verfahrens geschaffen werden.

Die Aufgabe ist erfindungsgemäß durch die Maßnahmen des Patentanspruches 1 gelöst. Eine zugehörige Anordnung ist im Patentanspruch 8 angegeben. Weiterbildungen des Verfahrens und der zugehörigen Anordnung ergeben sich aus den jeweiligen Unteransprüchen.

Gegenstand der Erfindung ist ein neues Auswerteprinzip von auf dem Tunnelmagnetowiderstandseffekt beruhenden Magnetfeldsensoren. Dabei sind die Magnetfeldsensoren so ausgewählt, dass die Antwortsignale auf eine Widerstandsänderung in einer Feldrichtung eine bevorzugt konstante Spannungsabhängigkeit und in einer zweiten, vorzugsweise zur ersten antiparallelen Feldrichtung eine möglichst nichtlineare Spannungsabhängigkeit aufweist. Der so ausgebildete Magnetfeldsensor wird mit Wechselstrom betrieben, wobei das Auslesen der Signale ebenfalls mit Wechselstrom, aber mit einer von der Einprägespannung unterschiedlichen Frequenz erfolgt, wobei die Messfrequenz von der Grundfrequenz abhängig ist. Mit einer spezifischen Wahl der Auswertefrequenz ergeben sich beachtliche Verbesserungen in der Auswertung.

Das erfindungsgemäße Verfahren macht sich eine Besonderheit des TMR-Effektes zu Nutze. Ein wesentlicher Vorteil liegt darin, dass durch die Trennung von Detektionsfrequenz und Anregefrequenz in Kombination mit einer an sich bekannten Lock-in-Verstärkungstechnik eine rauscharme Messung möglich ist.

Die neue Auswertemethode erlaubt die Verstärkung durch einen schmalbandigen Wechselspannungsverstärker, bei dem Störungen anderer Frequenzen und DC-Anteile nicht mitverstärkt werden, und eine anschließende Demodulation, indem das Messsignal mit einem Referenzsignal phasensynchron multipliziert wird. Im Ergebnis ergibt damit sich eine phasenempfindliche Gleichrichtung. Abschließend erfolgt eine Glättung mit einem Tiefpassfilter.

Weitere Einzelheiten und Vorteile der Erfindung ergeben sich aus nachfolgender Figurenbeschreibung von Ausführungsbeispielen anhand der Zeichnung in Verbindung mit den Patentansprüchen.

Es zeigen

Figur 1    Strom-Spannungsverläufe einer typischen TMR-Zelle,
Figur 2    den aus Figur 1 bestimmten Verlauf des Widerstand der TMR-Zelle und den daraus berechneten TMR-Effekt,
Figur 3    eine schematische Darstellung des erfindungsgemäßen Sensor-/Auswertekonzeptes,
Figur 4    ein Frequenzspektrum des Sensorsignals $U_A$ in Abhän- gigkeit der Orientierung der Mess- und Referenzschicht und
Figur 5    eine Messanordnung zur Realisierung des erfindungsge- mäßen Verfahrens.

Magnetfeldsensoren nach dem Tunnelmagnetowiderstandseffekt (TMR = Tunnel Magneto Resistance) sind vom Stand der Technik bekannt. In der Praxis werden allerdings TMR-Sensoren bisher kaum eingesetzt. In jüngerer Zeit wurden erste Anwendungen als Leseköpfe in Festplattenlaufwerken vorgeschlagen. Man verspricht sich von TMR-basierten Leseköpfen weitere Fortschritte in der magnetischen Aufzeichnungsdichte.

Daneben ist der TMR-Effekt seit längerer Zeit Gegenstand von Untersuchungen zu magnetischen Speicher (MRAM)- und Logik(ML)-Anwendungen.

In der Regel wird der Widerstand eines TMR-Sensors mittels einer Gleichspannung gemessen. Es sind mehrere Ausgestaltungsformen für TMR Sensoren bekannt, mit denen sich idealerweise ein linearer Zusammenhang zwischen dem Widerstand und dem angelegten Feld ergeben sollte, z. B. eine 90°-Ausrichtung der Magnetisierung von Mess- und Referenzschicht.

Nunmehr soll statt einer Gleichspannung eine Wechselspannung einer Grundfrequenz $f_0$ an den TMR-Sensor angelegt werden und als Response-Signal die zeitliche Antwort im Widerstand bei einer von der Grundfrequenz $f_0$ verschiedenen Frequenz $f_1$ detektiert werden. Sinnvollerweise hängt die Frequenz $f_1$ in einfacher Weise von der Frequenz $f_0$ ab. Beispielsweise bildet sie eine Harmonische, z. B. die zweite Harmonische, d.h. $f_1 = 2f_0$.

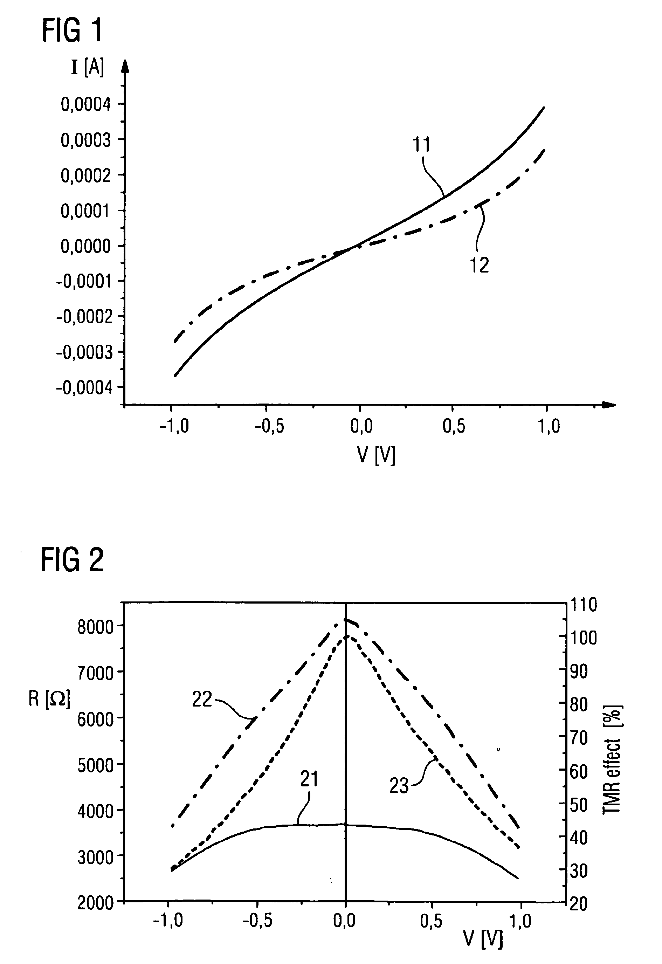

In Figur 1 ist der Strom-Spannungsverlauf einer typischen TMR-Zelle, bei der eine Tunnelbarriere aus Magnesiumoxid (MgO) vorliegt, dargestellt. Aufgetragen ist auf der Abszisse die Spannung in Volt (V) und auf der Ordinate der Strom in Ampere (A) bzw. Milliampere (mA).

Figur 1 zeigt typische Strom-Spannungskennlinien für eine derartige magnetische Tunnelzelle. Der Graph 11 kennzeichnet eine Kennlinie für parallele Ausrichtung der Magnetisierung von Mess- und Referenzschicht und der Graph 12 kennzeichnet eine Kennlinie für eine antiparallele Ausrichtung der Mess- und Referenzschicht.

Aus dem Strom-Spannungsverlauf lässt sich an jedem Punkt der beiden Kurven der Widerstand aus dem Ohmschen Gesetz R = U/I bilden. Im Einzelnen ist der Widerstand jeweils durch eine inverse differentielle Ableitung beider Kurven 11 und 12 gebildet.

Die in Figur 1 bzw. daraus abgeleiteten Kurvenverläufe der Figur 2 sind typisch für die in letzter Zeit in das allgemeine Interesse der Anwendung gerückten Magnesiumoxid(MgO)-Barrieren. Solche MgO-Barrieren versprechen sowohl theoretisch als auch praktisch extrem hohe TMR-Effekte (> 100 %), da dort eine starke spinabhängige Absorption von Ladungsträgern im Barrierematerial beobachtet wird.

In Figur 2 ist der aus Figur 1 berechnete Widerstandsverlauf in Abhängigkeit von der Spannung gezeigt. Auf der Abszisse ist entsprechend Figur 1 die Spannung aufgetragen, während auf der linken Ordinate der Widerstand in $\Omega$, der nach dem Ohmschen Gesetz berechnet wurde, und auf der rechten Ordinate der TMR-Effekt in % aufgetragen sind.

Der TMR-Effekt lässt sich aus dem Widerstand als Funktion der an eine MgO-basierende Tunnelzelle angelegten Spannung bestimmen. Im Einzelnen ist mit dem Graphen 21 der Widerstand aus einer parallel strukturierten TMR-Zelle und mit 22 der Widerstand aus einer antiparallel strukturierten TMR-Zelle bezeichnet. Bezugszeichen 23 kennzeichnet den daraus bestimmten TMR-Effekt, der sich aus der Beziehung

$$T_{MR} \ = \ \frac{R_{Ap} - R_P}{R_P} \qquad\qquad (1)$$

ergibt,

wobei $R_{Ap}$ den Widerstand einer TMR-Zelle, bei der die beiden der Tunnelbarriere benachbarten magnetischen Schichten antiparallel magnetisiert sind, und $R_p$ den Widerstand einer entsprechend parallel magnetisierten TMR-Zelle bedeuten.

Charakteristisch in Figur 2 ist bei dem dort gezeigten Widerstandsverlauf ein ausgeprägtes Plateau des Widerstandes R in der parallelen Ausrichtung der Schichten entsprechend Graph 21 und eine ausgeprägte Spannungsabhängigkeit des Widerstandes R in der antiparallelen Ausrichtung der Schichten entsprechend Graph 22. Erkennbar ist aus Graph 23, der den aus Gl. (1) errechneten Tunneleffekt darstellt, dass der TMR-Effekt bei der Spannung Null maximal ist und in etwa symmetrisch mit der angelegten Spannung abfällt.

Die in Figur 2 dargestellte Abhängigkeit wird nun messtechnisch folgendermaßen ausgenutzt:

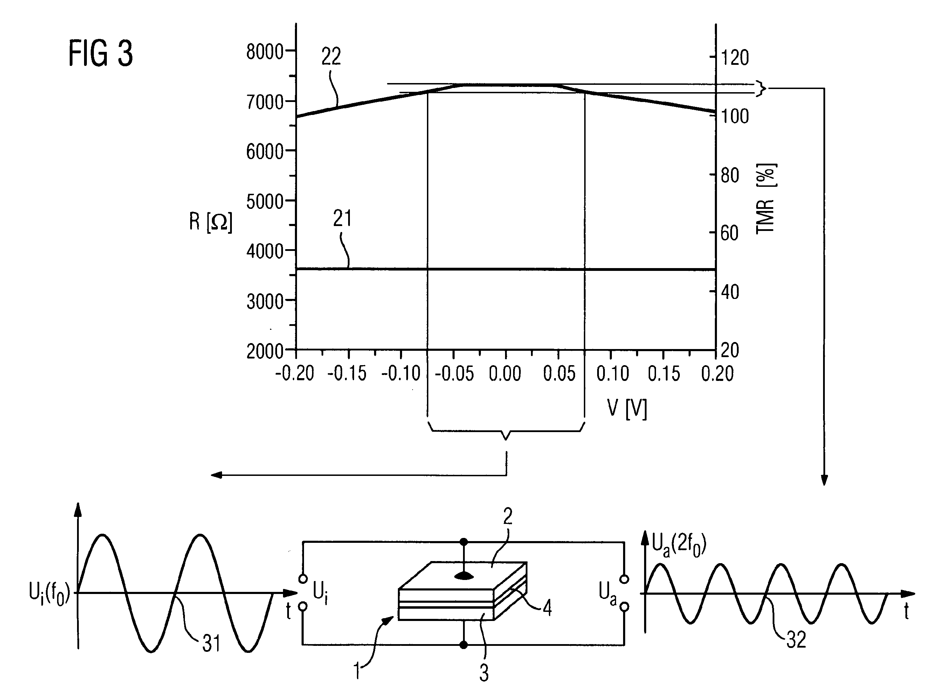

Wird an eine TMR-Zelle eine Wechselspannung $U_i$ mit der Frequenz $f_0$ angelegt, so ändert sich der Widerstand bei antiparalleler Ausrichtung der Magnetisierungen gemäß dem in Figur 3 gezeigten Verlauf 22, der eine vergrößerte Darstellung von Figur 2 darstellt: Eine über der Zelle abgegriffene Messspannung $U_a$ wird einen hohen Anteil quadratischer Komponenten beinhalten, während in paralleler Ausrichtung der magnetischen Schichten ein näherungsweise konstanter Widerstandsverlauf 23 zu beobachten ist, wodurch der Anteil an höheren Harmonischen verschwindend sein wird. Nach einer phasenempfindlichen Gleichrichtung wird das Messsignal $U_a$ demnach einen Anteil der doppelten Grundfrequenz beinhalten, der eine Aussage darüber zulässt, wieweit die beiden Schichten antiparallel zueinander ausgerichtet sind. Der Frequenzanteil $2f_0$ stellt damit eine feldabhängige Messgröße dar.

Das vorstehend eher prinzipiell beschriebene Auswertekonzept wird im Weiteren näher erläutert: In Figur 3 ist ein Magnetfeldsensor, der nach dem Tunnelmagnetoeffekt arbeitet, mit 1 bezeichnet. Es sind zwei Schichten 2 und 3 dargestellt, die magnetisch parallel oder antiparallel orientiert sein können. Zwischen den Schichten 2 und 3 ist eine Barriereschicht 4 vorhanden, die insbesondere aus Magnesiumoxid (MgO), aber auch aus Aluminiumoxid ($Al_2O_3$) bestehen kann.

Der Magnetfeldsensor gemäß Figur 3 wird mit einer Spannung $U_i$ beaufschlagt und es wird eine Spannung $U_a$ gemessen. Wie vorstehend beschrieben, wird für $U_a$ erfindungsgemäß eine Wechselspannung verwendet. Die dabei an dem Tunnelwiderstand 1 abfallende Spannung ergibt sich aus dem Widerstand des Feldsensors. Dabei ist die Wechselspannung $U_i(f_0)$ durch die sinusförmige Kurve 31 verdeutlicht. Das Frequenzspektrum der über dem Tunnelwiderstand abfallenden Spannung $U_a$ beinhaltet neben der Grundfrequenz noch Anteile der doppelten Grundfrequenz $2f_0$.

Vorteilhaft ist bei der Verwendung hochohmiger Tunnelbarrieren, dass sehr kleine Ströme fließen werden, die dem Verfahren extrem leistungsarme Sensoren ermöglichen. Trotzdem können diese Sensoren durch die Verwendung der Lock-in-Technik äußerst rauscharm gestaltet werden, was für den Einsatz in der praktischen Messtechnik von großer Bedeutung ist.

Durch eine rechentechnische Simulation kann das der Erfindung zugrunde liegende Prinzip des beschriebenen Messverfahrens weiter verdeutlicht werden. Die beiden in Figur 2 gezeigten Widerstandsverläufe wurden durch analytische Funktionen gefittet, wobei der Strom durch die Tunnelzelle beim Anlegen einer sinusförmigen Spannung

$$U_i \sim U_o \sin(\omega t) \qquad\qquad (2)$$

für beide Zustände, d.h. antiparallel bzw. parallel, ermittelt wurde. Exemplarisch wurde für $U_i$ eine Frequenz $f_0$ von 26 Hz und eine Amplitude von 200 mV gewählt. Die sich ergebende Spannung $U_a$ wurde mittels schneller Fourier-Transformation (FFT = fast fourier transformation) in ihre spektralen Komponenten zerlegt.

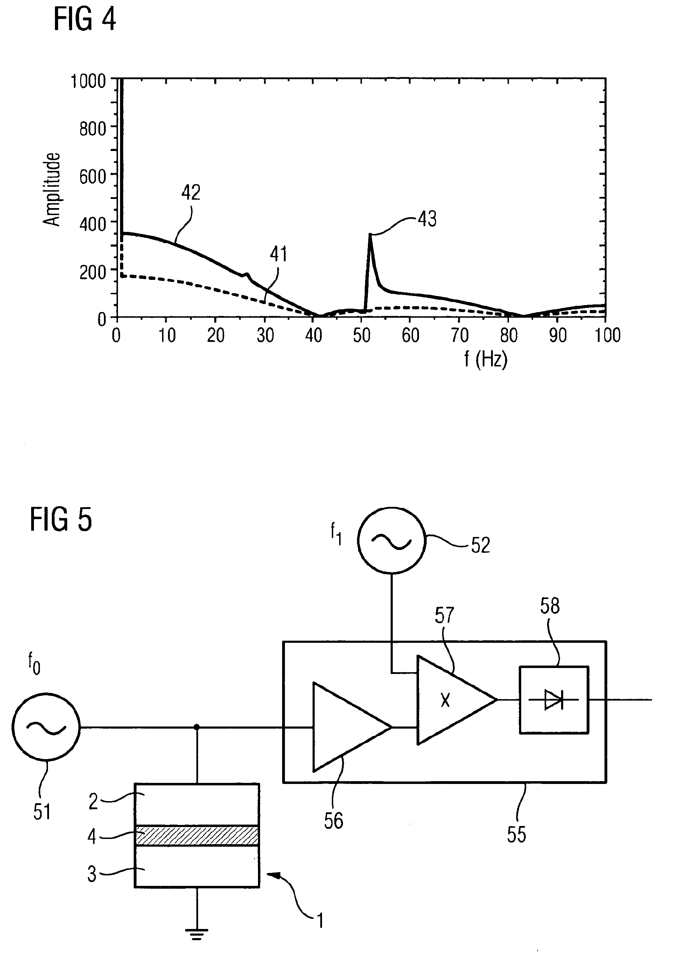

Letzterer Sachverhalt ist in Figur 4 im Einzelnen dargestellt. Aufgetragen ist auf der Abszisse die Frequenz in Hertz und auf der Ordinate die Amplitude des Signals in willkürlichen Einheiten. Mit 41 ist der Graph für eine Messschicht parallel zur Referenzschicht und mit 42 der Graph für eine Messschicht antiparallel zur Referenzschicht dargestellt. Insbesondere der Graph 42 für die antiparallele Orientierung zeigt im Frequenzbereich von 52 Hz, d.h. etwa bei $2 f_0$, einen Peak 43 als scharf ausgeprägtes Signalmaximum. Der Frequenzbereich um das Maximum, beispielsweise zwischen 48 und 55 Hz, wird durch eine Lock-in-Technik gezielt für Messzwecke der Aufgabenstellung ausgenutzt.

Das Ergebnis wird anhand Figur 4 deutlich: Während im Fall der parallelen Ausrichtung entsprechend Graph 41 kein messbares Signal mit der zweiten Harmonischen der Grundfrequenz $f_0$ entsteht, ist dies in der antiparallelen Ausrichtung entsprechend Graph 42 von Mess- und Referenzschicht deutlich erkennbar.

In Figur 5 ist eine zugehörige Schaltungsanordnung dargestellt, die das neue Auswertekonzept realisiert. Mit 1 ist wiederum der Magnetfeldsensor, der nach dem Magnetotunneleffekt arbeitet, bezeichnet. 51 kennzeichnet einen Frequenzgenerator für die Grundfrequenz $f_0$ und 52 einen Frequenzgenerator für die Referenzfrequenz $f_1$. Ein Lock-in-Verstärker ist mit 55 bezeichnet. Der Lock-in-Verstärker 55 besteht aus dem Eingangsverstärker 56, einem Multiplikationsglied 57 und einem nachfolgenden Gleichrichter 58.

Mit der beschriebenen Schaltungsanordnung wird eine phasensynchrone Demodulation durchgeführt. Das Ausgangssignal kennzeichnet das feldabhängige Antwortsignal des Magnetfeldsensors 1.

Anhand der vorstehend erläuterten Figuren gezeigten Anordnung ergibt sich aufgrund von externen Feldern die Ausrichtung von Referenz- und Messschicht. Damit wird der Anteil der zweiten Harmonischen in der Messfrequenz beeinflusst, der mittels externer felderzeugender Mittel gegenkompensiert werden kann. Das Regelsignal stellt damit die Messgröße dar.

Mit dem beschriebenen Magnetfeldsensor ist eine Anwendung bei Feldsensoren möglich, wie Stromsensoren, Leseköpfe oder insbesondere auch Biosensoren. Bei Letzterem kann gegebenenfalls auch eine Verbindung mit magnetischen Beads erfolgen. Es sind weiterhin fernabfragbare bzw. potentialfreie Sensoren möglich, bei denen eine Spannung $U_0$ mittels einer RF-Antenne an ein Abfragefeld eines Senders gekoppelt sein kann. Die Ausgangsspannung $U_a$ des TMR-Sensors wird dann über eine weitere Antenne an das Empfangsfeld eines Empfängers gekoppelt.

Der vorstehend beschriebene Magnetfeldsensor hat insgesamt den Vorteil des leistungsarmen Messprinzips. Dabei ist er trotzdem rauscharm. Weiterhin kann durch die wechselnde Stromrichtung aufgrund des so genannten Spin-Torque-Effektes ein wechselndes Moment auf die Magnetisierung der Messschicht wirken, was sich wiederum günstig auf die Hysterese des Sensors auswirkt.

Insgesamt wird deutlich, dass bei einem bekannten Magnetfeldsensor, der auf dem Tunnelmagnetowiderstandseffekt beruht, messtechnisch derart vorgegangen wird, dass der Sensor mit einer Wechselspannung vorgegebener Grundfrequenz ($f_0$) und Amplitude (A) angeregt wird, und das Responsesignal des Widerstandes bei einer von der Grundfrequenz ($f_0$) verschiedenen Frequenz ($f_1$) gemessen wird. Bei der zugehörigen Anordnung sind Mittel zur Detektion und Auswertung von Response-Signalen vorhanden, wobei die Spannungsquelle eine Wechselspannungsquelle ist und wobei die Mittel zur Detektion bei einer anderen Frequenz ($f_1$) als die Frequenz ($f_0$) Spannungsgenerators zur Versorgung arbeiten.

**Patentansprüche**

1.  Verfahren zum Betreiben eines Magnetfeldsensors basierend auf dem Tunnelmagnetowiderstandseffekt, mit folgenden Maßnahmen:

    - der Magnetfeldsensor ist als magnetfeldabhängiger Widerstand ausgeführt und wird so ausgewählt, dass der Widerstandsverlauf des Magnetfeldsensors in Abhängigkeit von der am Magnetfeldsensor anliegenden Spannung ein ausgeprägtes Plateau bei paralleler Ausrichtung der Magnetisierungen der Schichten des Magnetfeldsensors und eine ausgeprägte Spannungsabhängigkeit in der antiparallelen Ausrichtung der Magnetisierungen aufweist,
    - an den derartig beschaffenen Magnetfeldsensor wird eine Wechselspannung vorgegebener Grundfrequenz ($f_0$) und Amplitude angelegt,
    - das Antwort-Signal des Widerstandes wird bei einer von der Grundfrequenz ($f_0$) verschiedenen Frequenz ($f_1$) gemessen, wobei die Messfrequenz ($f_1$) in vorgegebener Art von der Grundfrequenz ($f_0$) abhängt,

    **dadurch gekennzeichnet, dass**
    die Amplitude der gleichen Spannung ausgewählt wird, bei der der TMR-Effekt auf die Hälfte abgesunken ist, wobei der TMR-Effekt berechenbar ist über

    $$T_{MR} = \frac{R_{Ap} - R_P}{R_P},$$

    wobei

    - $R_{Ap}$ den Widerstand der TMR-Zelle bedeutet, wenn die beiden magnetischen Schichten antiparallel magnetisiert sind, und
    - $R_p$ den Widerstand der TMR-Zelle bedeutet, wenn die beiden magnetischen Schichten parallel magnetisiert sind.

2.  Verfahren nach Anspruch 1, **dadurch gekennzeichnet, dass** die Messfrequenz ($f_1$) eine Harmonische, vorzugsweise die zweite Harmonische, von der Grundfrequenz ($f_0$) bildet.

3.  Verfahren nach Anspruch 1 oder Anspruch 2 mit folgenden Maßnahmen:

    - Es wird eine Verstärkung des Messsignals durch einen schmalbandigen Verstärker vorgenommen,
    - anschließend erfolgt eine Demodulation, indem das Messsignal mit einem Referenzsignal phasensynchron multipliziert wird,
    - danach wird das modulierte Signal durch einen Tiefpassfilter geglättet.

4.  Verfahren nach einem der vorhergehenden Ansprüche, **dadurch gekennzeichnet, dass** der durch die Spannung der ausgewählten Amplitude erzeugte Tunnelstrom ein magnetisches Drehmoment zwischen Referenzschicht und Messschicht überträgt, das groß genug ist, um die Magnetisierung der Messschicht reversibel aus der statischen Gleichgewichtslage zu drehen.

5.  Verfahren nach Anspruch 4, wobei der reversibel übertragene Drehimpuls verwendet wird, um Irreversibilitäten der Messschicht zu unterdrücken.

6.  Verfahren nach einem der vorhergehenden Ansprüche, wobei die Amplitude einer oder mehrer Oberwellen der Grundfrequenz als Messsignal zur Bestimmung von Magnetfeldern genutzt wird.

7.  Anordnung, konfiguriert zur Durchführung aller Schnitte des Verfahrens nach Anspruch 1 oder einem der Ansprüche 2 bis 6, mit einem Magnetfeldsensor nach dem Tunnelmagnetoeffekt (TMR), der mit einer Spannung anregbar ist und Mittel zur Detektion und Auswertung von Antwort-Signalen auf die Widerstandsänderung aufweist, **dadurch gekennzeichnet, dass** die Spannungsquelle eine Wechselspannungsquelle (51) ist und dass die Mittel (10) zur Detektion des Sensor-Signals bei einer anderen Frequenz ($f_1$) als die Frequenz ($f_0$) der Versorgungsspannungsquelle (51) ausgebildet sind.

**8.** Anordnung nach Anspruch 7, **dadurch gekennzeichnet, dass** ein Lock-in-Verstärker (10) vorhanden ist.

**9.** Anordnung nach Anspruch 8, **dadurch gekennzeichnet, dass** Mittel (57, 58) zur phasenempfindlichen Gleichrichtung vorhanden sind.

**10.** Anordnung nach Anspruch 8, **dadurch gekennzeichnet, dass** wenigstens ein Tiefpassfilter vorhanden ist.

**11.** Anordnung nach Anspruch 8, **dadurch gekennzeichnet, dass** die Tunnelbarriere einen Flächenwiderstand(RA) $< 1000\ \Omega\mu m^2$ besitzt, vorteilhafterweise $< 100\ \Omega\mu m^2$.

**12.** Anordnung nach Anspruch 8, wobei die Tunnelbarrieren (4) vorzugsweise aus Aluminiumoxid ($Al_2O_3$) oder Magnesiumoxid (MgO) bestehen.

**13.** Anordnung nach Anspruch 8, **dadurch gekennzeichnet, dass** das Messsignal über mindestens zwei Messkontakte auf gegenüberliegenden Seiten der Tunnelbarriere abgegriffen wird.

**14.** Anordnung nach Anspruch 8, **dadurch gekennzeichnet, dass** das Messsignal durch eng benachbarte Kontakte auf lediglich einer Seite der Tunnelbarriere abgegriffen wird.

**Claims**

**1.** Method for operating a magnetic field sensor based on the tunnel magneto resistance effect, with the following steps:

- the magnetic field sensor is embodied as a magnetic-field-dependent resistance and is selected such that the resistance characteristic of the magnetic field sensor has a pronounced plateau in the case of parallel orientation of the magnetisations of the layers of the magnetic field sensor and a pronounced voltage dependency in the antiparallel orientation of the magnetisations, as a function of the voltage present at the magnetic field sensor,
- an alternating voltage of a predefined base frequency ($f_0$) and amplitude (A) is applied to the thus obtained magnetic field sensor,
- the response signal of the resistance is measured at a frequency ($f_1$) that differs from the base frequency ($f_0$), the measuring frequency ($f_1$) depending in a predefined manner on the base frequency ($f_0$),

**characterised in that**
the amplitude of the same voltage at which the TMR effect has dropped to half is selected,
it being possible to calculate the TMR effect using

$$T_{MR} = \frac{R_{Ap} - R_p}{R_p}$$

where

- $R_{Ap}$ is the resistance of the TMR cell, if the two magnetic layers are magnetised in antiparallel fashion, and
- $R_p$ is the resistance of the TMR cell if the two magnetic layers are magnetised in parallel fashion.

**2.** Method according to claim 1, **characterised in that** the measuring frequency ($f_1$) forms a harmonic, preferably the second harmonic, of the base frequency ($f_0$).

**3.** Method according to claim 1 or claim 2 with the following steps:

- an amplification of the measured signal is effected by a narrowband amplifier,
- a demodulation then occurs, in that the measured signal is multiplied phase-synchronously by a reference signal,
- subsequently the modulated signal is smoothed by a low-pass filter.

**4.** Method according to one of the preceding claims, **characterised in that** the tunnel current generated by the voltage of the selected amplitude transfers a magnetic torque between reference layer and measured layer which is big enough to rotate the magnetisation of the measured layer reversibly from the static equilibrium position.

**5.** Method according to claim 4, wherein the reversibly transmitted rotary pulse is used to suppress irreversibilities in the measured layer.

**6.** Method according to one of the preceding claims, wherein the amplitude of one or more harmonics of the base frequency is used as a measured signal to determine magnetic fields.

**7.** Arrangement configured to implement all steps in the method according to claim 1 or one of claims 2 to 6, having a magnetic field sensor in accordance with the tunnel magneto effect (TMR) which can be excited with a voltage and which comprises means for detecting and evaluating response signals to the change in resistance, **characterised in that** the voltage source is an alternating current voltage source (51) and the means (10) for detecting the sensor signal are embodied at a frequency ($f_1$) that differs from the frequency ($f_0$) of the supply voltage source (51).

**8.** Arrangement according to claim 7, **characterised in that** a lock-in amplifier (10) is present.

**9.** Arrangement according to claim 8, **characterised in that** means (57, 58) for phase-sensitive rectification are present.

**10.** Arrangement according to claim 8, **characterised in that** at least one low-pass filter is present.

**11.** Arrangement according to claim 8, **characterised in that** the tunnel barrier possesses a surface resistance (RA) < 1000 $\Omega\mu m^2$, advantageously < 100 $\Omega\mu m^2$.

**12.** Arrangement according to claim 8, wherein the tunnel barriers (4) preferably consist of aluminium oxide ($Al_2O_3$) or magnesium oxide (MgO).

**13.** Arrangement according to claim 8, **characterised in that** the measured signal is picked off via at least two measured contacts on opposite sides of the tunnel barrier.

**14.** Arrangement according to claim 8, **characterised in that** the measured signal is picked off by closely adjacent contacts on only one side of the tunnel barrier.

## Revendications

**1.** Procédé pour faire fonctionner un capteur de champ magnétique sur la base de l'effet de magnétorésistance tunnel, comprenant les mesures suivantes :

- le capteur de champ magnétique, réalisé sous forme de résistance dépendant du champ magnétique, est sélectionné de telle façon que le tracé de résistance du capteur de champ magnétique en fonction de la tension appliquée à ce dernier présente un plateau prononcé dans le cas de l'alignement parallèle des aimantations des couches du capteur de champ magnétique, et une dépendance prononcée de la tension dans l'alignement antiparallèle des aimantations,
- au capteur de champ magnétique ainsi constitué est appliquée une tension alternative de fréquence fondamentale ($f_0$) et d'amplitude prédéterminées,
- le signal de réponse de la résistance est mesuré à une fréquence ($f_1$) distincte de la fréquence fondamentale ($f_0$), la fréquence de mesure ($f_1$) dépendant de manière prédéterminée de la fréquence fondamentale ($f_0$),

**caractérisé en ce que**
l'amplitude d'une même tension est sélectionnée, pour laquelle l'effet TMR a chuté à la moitié de sa valeur, ledit effet TMR pouvant être calculé par

$$T_{MR} = \frac{R_{Ap} - R_P}{R_P} ,$$

où

- $R_{Ap}$ signifie la résistance de la cellule TMR lorsque les deux couches magnétiques sont aimantées de façon antiparallèle, et
- $R_p$ signifie la résistance de la cellule TMR lorsque les deux couches magnétiques sont aimantées de façon parallèle.

2. Procédé selon la revendication 1, **caractérisé en ce que** la fréquence de mesure ($f_1$) constitue une harmonique, de préférence la deuxième harmonique, de la fréquence fondamentale ($f_0$).

3. Procédé selon la revendication 1 ou la revendication 2, comprenant les mesures suivantes :

- il est procédé à une amplification du signal de mesure par un amplificateur à bande étroite,
- une démodulation est ensuite réalisée, en multipliant le signal de mesure, de manière synchrone en terme de phase, par un signal de référence,
- puis le signal modulé est lissé par un filtre passe-bas.

4. Procédé selon l'une des revendications précédentes, **caractérisé en ce que** le courant tunnel généré par la tension de l'amplitude sélectionnée transmet un couple magnétique entre couche de référence et couche de mesure, qui est suffisamment grand pour sortir par rotation l'aimantation de la couche de mesure, de manière réversible, de la position d'équilibre statique.

5. Procédé selon la revendication 4, ledit couple transmis de manière réversible étant utilisé pour supprimer des irréversibilités de la couche de mesure.

6. Procédé selon l'une des revendications précédentes, l'amplitude d'une ou de plusieurs ondes harmoniques de la fréquence fondamentale étant utilisée comme signal de mesure pour la détermination de champs magnétiques.

7. Dispositif configuré pour la mise en oeuvre de toutes les étapes du procédé selon la revendication 1 ou l'une des revendications 2 à 6, comprenant un capteur de champ magnétique selon l'effet de magnétorésistance tunnel (TMR), qui peut être excité par une tension et qui présente des moyens de détection et d'évaluation de signaux de réponse à la variation de résistance, **caractérisé en ce que** la source de tension est une source de tension alternative (51) et **en ce que** les moyens (10) de détection du signal du capteur sont réalisés à une autre fréquence ($f_1$) que la fréquence ($f_0$) de la source de tension d'alimentation (51).

8. Dispositif selon la revendication 7, **caractérisé en ce qu'**un amplificateur lock-in (10) est présent.

9. Dispositif selon la revendication 8, **caractérisé en ce que** des moyens (57, 58) de redressement sensible à la phase sont présents.

10. Dispositif selon la revendication 8, **caractérisé en ce que** au moins un filtre passe-bas est présent.

11. Dispositif selon la revendication 8, **caractérisé en ce que** la barrière tunnel possède une résistance de surface (RA) < 1000 $\Omega\mu m^2$, de manière avantageuse < 100 $\Omega\mu m^2$.

12. Dispositif selon la revendication 8, les barrières tunnel étant de préférence en oxyde d'aluminium ($Al_2O_3$) ou en oxyde de magnésium (MgO).

13. Dispositif selon la revendication 8, **caractérisé en ce que** le signal de mesure est prélevé par l'intermédiaire d'au moins deux contacts de mesure sur des côtés opposés de la barrière tunnel.

14. Dispositif selon la revendication 8, **caractérisé en ce que** le signal de mesure est prélevé par des contacts voisines proches sur un seul côté de la barrière tunnel.

FIG 1

FIG 2

FIG 3

EP 2 126 596 B1

FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20040257186 A1
- WO 2005010543 A1
- US 20060138505 A1
- WO 2007042959 A2